# EUROPÄISCHE PATENTSCHRIFT

(11) **EP 0 275 941 B1**
(45) Veröffentlichungstag und Bekanntmachung des Hinweises auf die Patenterteilung: **30.03.1994**
(21) Anmeldenummer: 88100536.7
(22) Anmeldetag: 15.01.1988
(51) Int. Cl.: H03K 19/094

(54) **ECL-kompatible Eingangs-/Ausgangsschaltungen in CMOS-Technik**
ECL-compatible CMOS input/output circuits
Circuits d'entrée/sortie compatibles ECL réalisés en technologie CMOS

(30) Priorität: 23.01.1987 DE 3701986
(43) Veröffentlichungstag der Anmeldung: 27.07.1988
(73) Patentinhaber: SIEMENS AKTIENGESELLSCHAFT, 80333 München (DE)
(72) Erfinder: De Man, Erik, Dipl.-Ing., D-8000 München 83 (DE); Meier, Stefan, Dipl.-Ing., D-8000 München 83 (DE)

(56) Entgegenhaltungen:
- EP-A- 0 052 565
- EP-A- 0 102 643
- EP-A- 0 146 910
- EP-A- 0 220 870
- EP-A- 0 223 267
- EP-A- 0 231 062
- EP-A- 0 267 017
- WO-A-84/04009
- WO-A-85/02507
- WO-A-86/02792
- WO-A-86/07220
- US-A- 4 430 582
- US-A- 4 471 242
- US-A- 4 472 647
- US-A- 4 485 317
- A.H.Seidman, "Integrated Circuits Application Handbook", John Wiley & Sons, 1983, Seiten 311-313

## Beschreibung

Die Erfindung betrifft Eingangs-/Ausgangsschaltungen nach dem Oberbegriff des Anspruchs 1.

ECL- und CMOS-Schaltungen sind in der Halbleiterschaltungstechnik weit verbreitet, dabei besitzen die ECL-Schaltungen (= emittergekoppelte Logik) die kleinsten Schaltzeiten aller Logikfamilien. Diese liegen im Bereich von wenigen Nanosekunden und reichen zum Teil auch unter 1 ns. In CMOS-Schaltungen werden komplementäre MOSFET-Transistoren eingesetzt, dabei ist die ohmsche Ausgangsbelastung der CMOS-Schaltungen wegen der hohen Eingangswiderstände sehr niedrig. Je größer dabei die kapazitive Ausgangsbelastung ist, desto größer wird auch die Schaltzeit werden. Bei größerer kapazitiver Ausgangslast liegt sie in der Größenordnung von etwa 10 ns und darüber.

In zahlreichen Anwendungsfällen ist es nötig, CMOS-Schaltungen mit anderen Logikfamilien, so auch mit ECL-Logikschaltungen, zusammenzuschalten. Bei höheren Taktfrequenzen werden dabei zunehmend auch ECL-kompatible Eingangs-/Ausgangsschaltungen in CMOS-Technik erforderlich. Erschwert wird die Konzeption solcher Eingangs-/Ausgangsschaltungen durch eine Vielzahl von unterschiedlichen vorgeschriebenen Eingangs- und garantierten Ausgangspegeln der ECL-Schaltungen verschiedener Hersteller. Entsprechend müssen die Eingangs-/Ausgangsschaltungen so ausgelegt werden, daß auch die engsten Toleranzen für High- and Low-Pegel eingehalten werden können.

Für die Ausgangsschaltungen weisen beispielsweise die Siemens Gatearrays den kleinsten Bereich der zulässigen Eingangsspannungen auf. Hier gilt für die Pegel V high und V low
-1,025 Volt < V high < -0,880 Volt
-1,810 Volt <V low < -1,620 Volt
entsprechend den Konventionen in der ECL-Technik mit 0 Volt und -5 Volt Betriebsspannung.

In Konventionen der CMOS-Technik mit V_{DD} = 5 Volt und V_{SS} = 0 Volt folgt daraus:
3,975 Volt V high 4,120 Volt
3,190 Volt V low 3,380 Volt
Weiterhin müssen für den in Betracht kommenden Frequenzbereich die Ausgangsschaltungen darauf ausgelegt sein, Leitungen zu treiben, die mit einem Widerstand in der Größe des Wellenwiderstandes der Leitung abgeschlossen sind.

Die Eingangsschaltungen in CMOS-Technik müssen dabei so ausgelegt werden, daß sie auch beim kleinsten noch zulässigen Hub die Eingangssignale sicher als Low- oder High-Pegel unterscheiden können. Den kleinsten Ausgangshub haben dabei beispielsweise ECL-Schaltungen der Serie F.10K der Firma Fairchild. Hierfür gilt:
-1,100 Volt V high
V low -1,525 Volt
entsprechend den Konventionen in der ECL-Technik mit 0 Volt und -5 Volt Betriebsspannung.

Analog für die CMOS-Technik mit Pegeln von V_{DD} = 5 Volt, V_{SS} = 0 Volt gilt:
3,900 Volt V high
V low 3,475 Volt.

Eine weitere Anforderung an die Eingangs-/Ausgangsschaltungen in dem betrachteten Frequenzbereich liegt darin, eine Streuung der Laufzeit durch Transistorparameterschwankungen möglichst klein zu halten. Dies ist wichtig, damit beim Zusammenschalten von verschiedenen Schaltungen mit unterschiedlichen Transistorparametern ein korrektes Zeitverhalten für die Übertragung von Daten zwischen den Schaltungen sichergestellt wird.

Aus der US-Patentschrift 4,430,582 ist ein schneller CMOS-Puffer für TTL-Eingangssignale bekannt, bei dem die Ausgangsspannung eines eingangsseitig mit einer Referenzspannung beaufschlagten repräsentativen Gates mit einer weiteren Referenzspannung in einem Komparator verglichen wird, bei dem die Ausgangsspannung des Komparators auf die Basis eines zum repräsentativen Gate in Reihe geschalteten Bipolartransistor zurückgeführt ist und bei dem am Verbindungspunkt zwischen dem repräsentativen Gate und dem Bipolartransistor eine geregelte Versorgungsspannung für die Gates eines Gate-Arrays abgreifbar ist.

Die europäische Patentanmeldung mit der Veröffentlichungsnummer 0 267 017 bildet einen Stand der Technik im Sinne Art. 54 (3) EPÜ in den benannten Vertragsstaaten DE, FR, GB, IT, NL und betrifft einen Eingangspuffer, der eine Eingangsstufe enthält, die für TTL - als auch für CMOS-Pegel geeignet ist.

Die europäische Patentanmeldung mit der Veröffentlichungsnummer 0 223 267 stellt einen Stand der Technik nach Art. 54 (3) EPÜ in den benannten Ländern DE, FR, GB, NL dar und bezieht sich auf einen TTL/CMOS-kompatiblen Eingangspuffer, der ebenfalls sowohl für TTL als auch für CMOS-Eingangspegel geeignet ist.

Aus dem Integrated Circuits Applications Handbook von A. H. Seidmann, John Wiley & Sons, 1983, Seiten 311 bis 313, ist ein Stromdifferenzverstärker (Norton-Verstärker) bekannt.

Aus der europäischen Patentanmeldung mit der Veröffentlichungsnummer 0 102 643 ist eine Schaltung zur Pegelwandlung von ECL auf CMOS bekannt, bei der die Spannung einer Spannungserzeugungsschaltung zur Steuerung der Logik-Schwellenspannung einer ersten Eingangsschaltung benutzt wird.

Der Erfindung liegt die Aufgabe zugrunde, ECL-kompatible Eingangs-/Ausgangsschaltungen in CMOS-Technik herzustellen, die sehr enge ECL-Pegelanforderungen erfüllen und von Temperatur-und Transistorparameterschwankungen möglichst unabhängig sind.

Die Aufgabe wird durch die kennzeichnenden Merkmale des Anspruchs 1 gelöst.

Ausbildungen der Treiberstufen, der Sensorstufe, des Komparators, des Tiefpasses sowie der Referenzstromquelle sind Gegenstand der Unteransprüche und werden dort näher erläutert.

Die mit der Erfindung erzielten Vorteile bestehen insbesondere darin, daß alle ECL-Gatearrays der gängigen Hersteller mit den Eingangs-/Ausgangsschaltungen in CMOS-Technik verschaltet werden können. Eine Regelschaltung kompensiert dabei alle Temperatur- und Transistorparameterschwankungen und ist so ausgelegt, daß sie sowohl für die Eingangs- als auch für die Ausgangsschaltungen verwendet werden können.

Ein Ausführungsbeispiel der Erfindung ist in den Zeichnungen dargestellt und wird im folgenden näher beschrieben. Es zeigt
- Figur 1: die gesamte Eingangs-/Ausgangsschaltung mit Treiberstufen und der Regelschaltung, bestehend aus einer Sensorstufe, eines Komparators, eines Tiefpasses und einer Referenzstromquelle,
- Figur 2: eine Treiberstufe für eine Ausgangsschaltung in CMOS-Technik,
- Figur 3: eine Treiberstufe als Eingangsschaltung in CMOS-Technik,
- Figur 4: eine Sensorstufe in CMOS-Technik,
- Figur 5: einen Komparator in CMOS-Technik,
- Figur 6: einen Tiefpaß,
- Figur 7: eine Referenzstromquelle in CMOS-Technik.

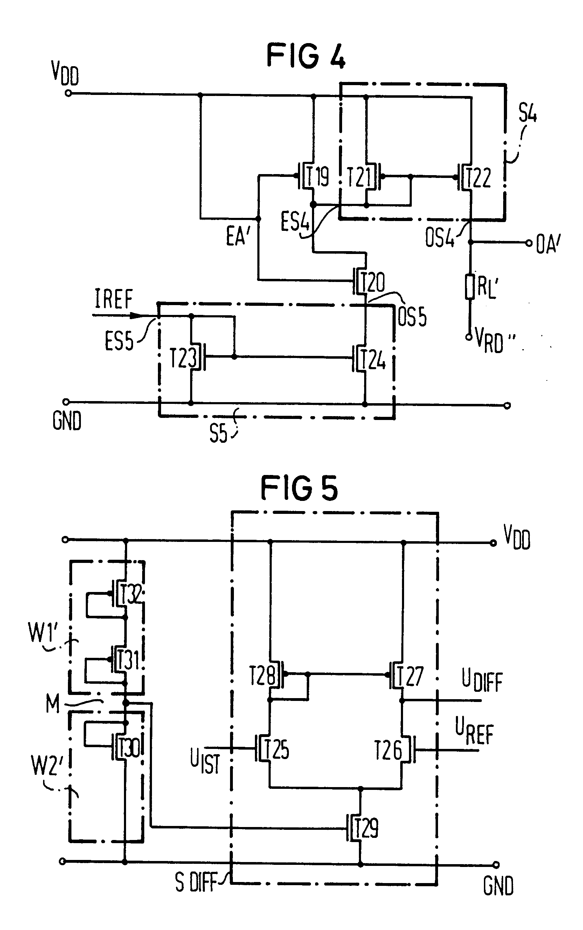

Figur 4, 5, 6 und Figur 7 bilden die Komponenten der Regelschaltung.

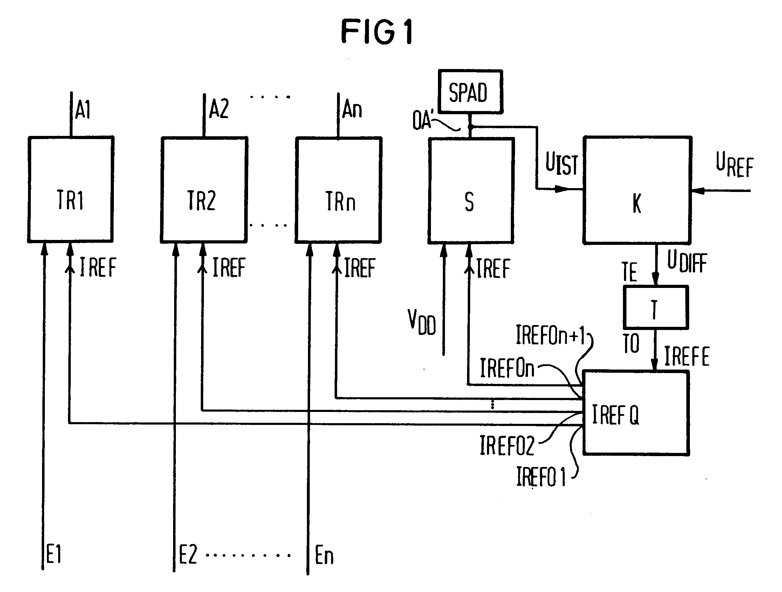

Figur 1 zeigt die Gesamtschaltung einer ECL-kompatiblen Eingangs-/Ausgangsschaltungen in CMOS-Technik. Die Treiberstufen TR1, TR2,...TRn enthalten wahlweise eine Eingangs- oder Ausgangsschaltung.

Um die V high-Pegel am Ausgang der Ausgangsschaltungen exakter einstellen zu können, kann man den eingeprägten Referenzstrom IREF je nach Schwankung der Technologie bedingten Parameter einstellen. Da eine externe Einstellung für den Referenzstrom IREF zu umständlich ist, wurde eine Regelschaltung aufgebaut. Hierfür wird zu den Treiberstufen TR1, TR2,...TRn eine Sensorstufe S hinzugefügt, die am Eingang so beschaltet ist, daß ihr Ausgang OAʹ immer auf V high liegt. Die gesamte Regelschaltung besteht aus der Sensorstufe S, dem Komparator K, dem Tiefpaß T und der Referenzstromquelle IREFQ. Der Komparator K enthält zwei Eingänge U_{IST}, U_{REF} für die Ist-Ausgangsspannung der Sensorstufe S und einer extern angelegten Referenzspannung (in Höhe des Sollwertes von V high). Das aus dem Vergleich von den zuletzt genannten Spannungsgrößen sich ergebende Signal wird vom Ausgang U_{DIFF} des Komparators über den Tiefpaß T in die Referenzstromquelle IREFQ eingespeist. Der Tiefpaß selbst enthält einen Eingang TE und einen Ausgang TO, während die Referenzstromquelle IREFQ einen Eingang IREFE, jedoch n+1 Ausgänge IREFO1, IREFO2, ... IREFOn, IREFOn+1 aufweist. Die Referenzstromquelle IREFQ ist daher so ausgebaut, daß zu jeder Treiberstufe TR1, TR2,...TRn eine eigene Leitung mit einem eingeprägten Referenzstrom IREF geführt wird. Dies ist nötig, da Transistoren, die eine Stromspiegelschaltung in den Treiberstufen bilden und mit dem Referenzstrom IREF versorgt werden, immer in unmittelbarer Nachbarschaft angeordnet werden müssen, um einen Einfluß von Parameterstreuungen innerhalb der gesamten Schaltung zu minimieren. Zusätzlich reagieren Leitungen mit eingeprägten Strömen nicht so empfindlich auf kapazitive Einkopplungen. Die Treiberstufen TR1, TR2,...TRn und die Sensorstufe S enthalten je einen Anschluß A1, A2,... An, SPAD für zusätzliche externe Bauelemente und zur Abnahme der Ausgangssignale. Eingangssignale der ECL-kompatiblen Eingangs-/Ausgangsschaltungen werden über die Eingänge E1, E2, ...En der Treiberstufen geführt. Da die Sensorstufe S am Ausgang immer auf V high liegen soll, wird ihr Eingang mit einer positiven Spannung V_{DD} beschaltet.

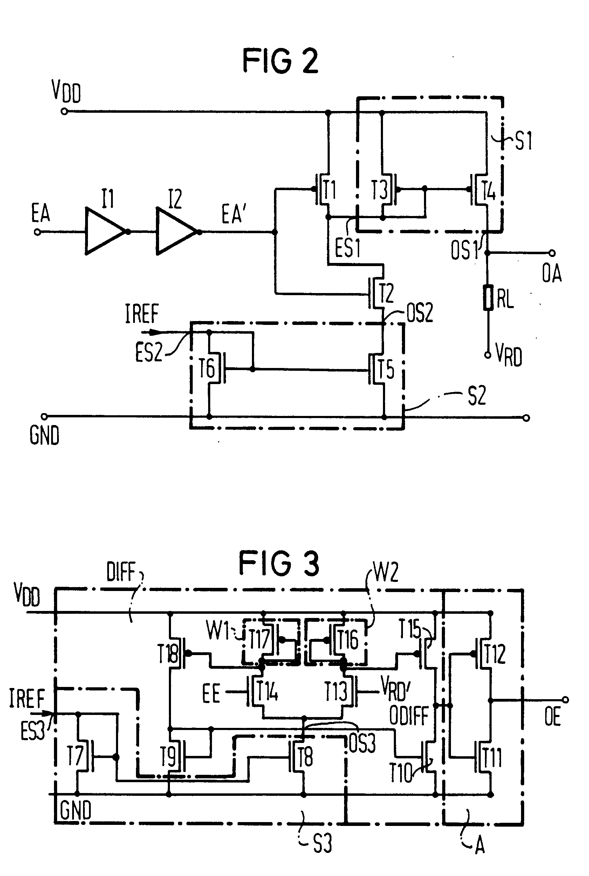

Figur 2 zeigt eine Treiberstufe, die als Ausgangsstufe aufgebaut ist und zwei Stromspiegelschaltungen S1, S2, einen externen Lastwiderstand RL, und ein Feldeffekttransistorpaar T1, T2 sowie mehrere vorgeschaltete Inverterstufen I1, I2 enthält. Der Eingang EA ist über die hintereinandergeschalteten Inverterstufen I1, I2 mit dem Eingang EAʹ verbunden, der mit dem Gate des p-Kanal-Feldeffekttransistors T1 und dem Gate des n-Kanal-Feldeffekttransistors T2 verbunden ist. Das Feldeffekttransistorpaar T1, T2 bildet dabei eine Serienschaltung, wobei der Sourceanschluß des p-Kanal-Feldeffekttransistors T1 mit der positiven Spannung V_{DD} und der Sourceanschluß des n-Kanal-Feldeffekttransistors T2 mit dem Ausgang OS2 der ersten Stromspiegelschaltung S2 verschaltet ist. Dieselbige Stromspiegelschaltung S2 ist mit der Masse GND verbunden und auf ihrem Eingang ES2 wird der eingeprägte Referenzstrom IREF angelegt. Die zweite Stromspiegelschaltung S1 ist hingegen mit einer positiven Spannung V_{DD} verbunden und ihr Eingang ES1 ist mit dem Drainanschluß des p-Kanal-Feldeffekttransistors T1 und dem Drainanschluß des n-Kanal-Feldeffekttransistors T2 verschaltet. Der Ausgang OS1 derselbigen Stromspiegelschaltung stellt zum einen den Ausgang OA der Ausgangsstufe dar und ist gleichzeitig über den Widerstand RL mit der Spannung VRD verbunden. Der Widerstand RL ist ein externer Widerstand und sein Widerstandswert beträgt 100 Ohm. Die Spannungshöhe der Spannung VRD wird zweckmäßigerweise auf +3,3 Volt festgelegt. Beide Stromspiegelschaltungen S1 und S2 werden jeweils mit zwei Feldeffekttransistoren aufgebaut. Die zweite Stromspiegelschaltung S1 enthält dabei zwei p-Kanal-Feldeffekttransistoren T3, T4, wobei der Gateanschluß des ersten p-Kanal-Feldeffekttransistors T3 und der Gateanschluß des zweiten p-Kanal-Feldeffekttransistors T4 mit dem Drainanschluß des ersten p-Kanal-Feldeffekttransistors T3 verbunden ist, der gleichzeitig auch den Eingang ES1 der zweiten Stromspiegelschaltung S1 bildet. Beide Sourceanschlüse der p-Kanal-Feldeffekttransistoren T3, T4 sind an eine positive Spannung V_{DD} angeschlossen, und der Ausgang OS1 der zweiten Stromspiegelschaltung wird durch den Drainanschluß des zweiten p-Feldeffekttransistors T4 gebildet. Die erste Stromspiegelschaltung S2 enthält zwei n-Kanal-Feldeffekttransistoren T6, T5 und ist so aufgebaut, daß ein Gateanschluß des ersten n-Kanal-Feldeffekttransistors T5 mit dem Gateanschluß und dem Drainschluß des zweiten n-Kanal-Feldeffekttransisotrs T6 verbunden ist, diese bilden gleichzeitig auch den Eingang ES2 der ersten Stromspiegelschaltung S2. Die Sourceanschlüsse der zwei n-Kanalfeldeffekttransistoren T6, T5 werden mit Masse GND verbunden und der Drainanschluß des ersten n-Kanal-Feldeffekttransistors bildet dabei den Ausgang OS2 der ersten Stromspiegelschaltung S2. Das Verhältnis der Kanalweiten der Feldeffekttransistoren in den Stromspiegelschaltungen beträgt bei der ersten Stromspiegelschaltung T3:T4 = 1:8,125 und bei der zweiten Stromspiegelschaltung T6:T5 = 1:10. Zum Schalten zwischen den Pegeln V high und V low wird das Feldeffekttransistorpaar T1, T2 in die Schaltung der Figur 2 eingefügt, die erste Stromspiegelschaltung S2 entkoppelt hierbei den eingeprägten Referenzstrom IREF von der nachfolgenden Stromspiegelschaltung.

In Figur 3 ist eine Treiberstufe als Eingangsstufe aufgebaut und enthält dafür eine Stromspiegelschaltung S3, eine Ausgangstreiberstufe A sowie einen Differenzverstärker DIFF. Stromspiegelschaltung S3, Ausgangstreiberstufe A und der Differenzverstärker DIFF sind mit Masse GND verbunden, wobei die beiden letzteren mit einer positiven Spannung V_{DD} zusätzlich verschaltet sind. Die Stromspiegelschaltung S3 weist einen Eingang ES3 auf, der mit einem Stromreferenzwert IREF belegt wird und ist mit seinem Ausgang OS3 mit dem Differenzverstärker DIFF verbunden. Da an seinem Ausgang ODIFF nicht unter allen Bedingungen (Schwankungen von Feldeffekttransistorparametern und der positiven Spannung V_{DD}) der volle CMOS-Hub anliegt, folgt eine Ausgangstreiberstufe A. Die Stromspiegelschaltung S3 mit dem geregelten Stromreferenzwert IREF am Eingang ES3 bewirkt bei einer Verschlechterung des Feldeffekttransistorparameter im Differenzverstärker DIFF den Zufuhr eines erhöhten Stromwertes über den Ausgang OS3.

Die Stromspiegelschaltung S3 enthält zwei n-Kanal-Feldeffekttransistoren T7, T8, wobei ein Gateanschluß des ersten Feldeffekttransistors T7 und ein Gateanschluß des zweiten Feldeffekttransistors T8 mit einem Drainanschluß des ersten Feldeffekttransistors T7 verbunden ist, der gleichzeitig einen Eingang ES3 der Stromspiegelschaltung S3 bildet. Der Sourceanschluß beider Feldeffekttransistoren T7, T8 ist mit der Masse GND verbunden und der Drainanschluß des zweiten Feldeffektransistors T8 bildet einen Ausgang OS3 der Stromspiegelschaltung S3. Das Kanalweitenverhältnis des ersten zum zweiten Feldeffekttransistor T7:T8 beträgt 1:1.

Die Ausgangstreiberstufe A enthält zwei in Serie geschaltete Feldeffekttransistoren T11, T12. Dabei ist ein p-Kanal-Feldeffekttransistor T12 mit einem Sourceanschluß auf die positive Spannung V_{DD} und ein n-Kanal-Feldeffekttransistor T11 mit einem Sourceanschluß auf Masse GND gelegt. Der Ausgang ODIFF des Differenzverstärkers DIFF wird mit dem Gateanschluß des p-Kanal-Feldeffekttransistors T12 und dem des n-Kanal-Feldeffekttransistors T11 verschaltet. Die Drainanschlüsse beider Feldeffekttransistoren bilden den Ausgang OA der Ausgangstreiberstufe A.

Der Differenzverstärker enthält vier n-Kanal-Feldeffekttransistoren T9, T10, T13, T14, zwei p-Kanal-Feldeffekttransistoren T15, T18 sowie zwei als Widerstände W1, W2 verschaltete p-Kanal-Feldeffekttransistoren T16, T17. Ein Sourceanschluß eines ersten und eines zweiten n-Kanal-Feldeffekttransistors T14, T13 ist mit dem Ausgang OS3 der Stromspiegelschaltung S3 verbunden, ein Gateanschluß des ersten n-Kanal-Feldeffekttransistors T14 ist mit dem ersten Eingang EE des Differenzverstärkers DIFF und ein Gateanschluß des zweiten n-Kanal-Feldeffekttransistors T13 an einen zweiten mit der Spannung VRDʹ belegten Eingang angeschlossen. Der erste Eingang EE wird später mit einem Eingang E1, E2,...En der Treiberstufen verbunden, während der zweite Eingang mit einer Spannung von -1,3 Volt belegt wird. Die Drainanschlüsse des ersten und zweiten n-Kanal-Feldeffekttransistors T14, T13 sind über einen ersten und einen zweiten Widerstand W1, W2 an eine positive Spannung V_{DD} angeschlossen.

Die letztgenannten Widerstände werden aus je einem p-Kanal-Feldeffekttransistor T17, T16 gebildet, wobei Gate- und Drainanschluß des jeweiligen p-Kanal-Feldeffekttransistors gemeinsam verschaltet sind. Der Drainanschluß des ersten n-Kanal-Feldeffekttransistors T14 ist mit einer aus einer ersten p-Kanal- und einem dritten n-Kanal-Feldeffekttransistor T18, T9 gebildeten Serienschaltung an den Gateanschluß des ersten p-Kanal-Feldeffekttransistors T18 und der Drainanschluß des zweiten n-Kanal-Feldeffekttransistors T13 mit einem aus einem zweiten p-Kanal- und einem dritten n-Kanal-Feldeffekttransistor T15, T10 gebildeten Serienschaltung an den Gateanschluß des zweiten p-Kanal-Feldeffekttransistors T15 verbunden. Die Serienschaltungen selbst werden untereinander über einen Gateanschluß und einen Drainanschluß des dritten n-Kanal-Feldeffekttransistors T9 mit dem Gateanschluß des vierten n-Kanal-Feldeffekttransistors T10 verschaltet. Beide Serienschaltungen erhalten über die Sourceanschlüsse des ersten p-Kanal-Feldeffekttransistors T18 und des zweiten p-Kanal-Feldeffekttransistors T15 die positive Spannung V_{DD} zugeführt, während die Sourceanschlüsse des dritten n-Kanal-Feldeffektranssitors T9 und des vierten n-Kanal-Feldeffekttransistors T10 mit Masse verschaltet sind.

Die Spannungsverstärkung der aus dem ersten und zweiten n-Kanal-Feldeffekttransistor T13, T14 und den p-Kanal-Feldeffekttransistoren T17, T16 gebildeten Eingangsdifferenzschaltung ist gering, da die p-Kanal-Feldeffekttransistoren T17, T16 als Widerstände geschaltet sind. Die eigentliche Spannungsverstärkung erfolgt in den beiden nachgeschalteten Serienschaltungen, wobei das zusammengesetzte Ausgangssignal am Ausgang ODIFF des Differenzverstärkers DIFF abgreifbar ist. Der an diesem Ausgang nicht unter allen Bedingungen, beispielsweise bei Schwankungen der Feldeffekttransistorparameter oder der Spannung V_{DD} der volle CMOS-Hub anliegt, wird das Ausgangssignal noch über eine nachgeschaltete Ausgangstreiberstufe A verstärkt.

Die in Figur dargestellte Sensorstufe S ist analog zu der in Fig. 2 dargestellten Ausgangsstufe aufgebaut. Sie enthält zwei Stromspiegelschaltungen S4 und S5, mit je einem Eingang ES4, ES5 und je einem Ausgang OS4 und OS5. Die Stromspiegelschaltungen S4 und S5 werden jeweils aus zwei Feldeffekttransistoren, zwei p-Kanal-Feldeffekttransistoren T21, T22 bei der Stromspiegelschaltung S4 und zwei n-Kanal-Feldeffekttransistoren T23 und T24 bei der Stromspiegelschaltung S5, gebildet. Der Eingang EAʹ der aus dem n-Kanal-Feldeffekttransistor T19 und dem p-Kanal-Feldeffekttransistor T20 gebildeten Serienschaltung ist jedoch im Gegensatz zur Ausgangsstufe in Figur 2 direkt mit der positiven Spannung V_{DD} verschaltet. Aus diesem Grunde liegt am Ausgang OAʹ der Sensorstufe S immer das Potential V high.

Um den Stromverbrauch der Sensorstufe S zu verringern, kann man den externen Lastwiderstand RLʹ auf 1 KOhm erhöhen, und den Feldeffekttransistor T22 um den Faktor 10 schmaler auslegen. Dies bedeutet, daß seine Kanalweite W statt 1300 µm in Figur 2 jetzt nur noch 130 µm beträgt. Die Spannung VRDʺ für den Lastwiderstand RLʹ ist analog wie die Spannung VRD in Figur 2 auf eine Höhe von +3,3 V eingestellt.

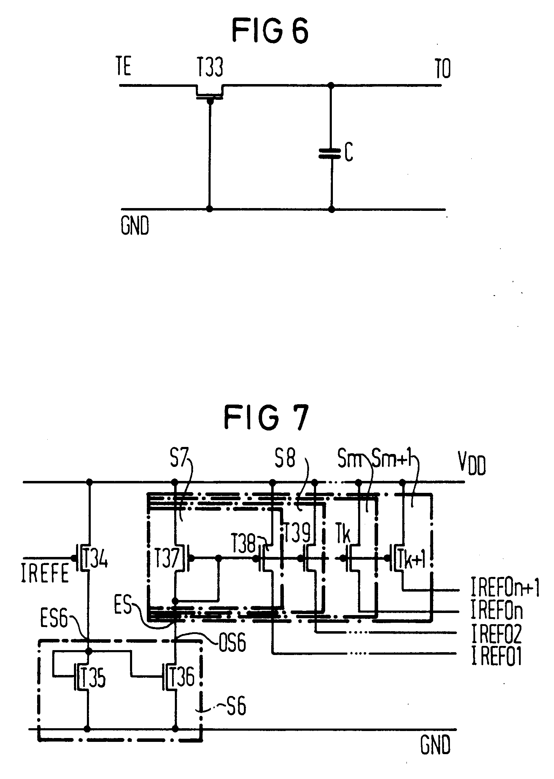

Der Komparator K in Figur 5 enthält einen Differenzverstärker mit Stromspiegelschaltung SDIFF und zusätzlich zwei in Serie geschaltete Widerstände W1ʹ, W2ʹ. Der Differenzverstärker wird dabei aus zwei n-Kanal-Feldeffekttransistoren T25, T26 mit je einem Eingang U_{IST}, U_{REF} gebildet. Beide Sourceanschlüsse der zuletzt genannten Feldeffekttransistoren sind über einen Drainanschluß eines dritten n-Kanal-Feldeffektransistors T29 an die Masse GND angeschlossen. Die Steuerung dieses dritten n-Kanal-Feldeffekttransistors T29 wird über einen Spannungsteiler, der aus den Widerständen W1ʹ, Wʹ gebildet wird, vorgenommen. Hierzu ist der Gateanschluß des dritten n-Kanal-Feldeffekttransistors T29 mit dem Verbindungspunkt M des Spannungsteilers verbunden. Die Stromspiegelschaltung enthält zwei p-Kanal-Feldeffekttransistoren T27, T28, deren beider Sourceanschlüsse an der positiven Spannung V_{DD} und ein Drainanschluß des ersten p-Kanal-Feldeffekttransistors T28 mit den Gateanschlüssen der ersten und zweiten p-Kanal-Feldeffekttransistors T28, T27 verschaltet ist. Da die Stromspiegelschaltung dem Differenzverstärker nachgeschaltet ist, sind die Drainanschlüsse des ersten p-Kanal-und des ersten n-Kanal-Feldeffekttransistors T28, T25 sowie die Drainanschlüsse des zweiten p-Kanal- und zweiten n-Kanal-Feldeffekttransistors T27, T26 miteinander verschaltet. Die Drainanschlüsse der letzten beiden Feldeffekttransistoren bildet gleichzeitig auch den Ausgang UDIFF des Komparators, an dem das Ausgangssignal abgegriffen werden kann.

Der erste Widerstand W1ʹ der Spannungsteilerschaltung wird aus zwei in Serie geschalteten p-Kanal-Feldeffekttransistoren T31, T32 gebildet, wobei Gate- und Drainanschluß der gleichen P-Kanal-Feldeffekttransistoren gemeinsam verschaltet sind. Für den zweiten Widerstand W2ʹ der Spannungsteilerschaltung wird lediglich ein n-Kanal-Feldeffekttransistor T32 benötigt, dessen Gate- und Drainanschlüsse zusammengelegt sind.

Der in Figur 6 dargestellte Tiefpaß für die Regelschaltung besteht lediglich aus zwei Komponenten, einem als Widerstand benutzter p-Kanal-Feldeffekttransistor T33 mit minimaler Kanalweite und einem Kondensator C der Größe 2-3 pF, der gemeinsam mit dem Gateanschluß des p-Kanal-Feldeffekttransistors T33 im Querzweig liegt. Der Eingang TE und der Ausgang TO des Tiefpasses sind jeweils mit dem Drain-bzw. Sourceanschluß des Feldeffekttransistors T33 verbunden.

Figur 7 zeigt die Referenzstromquelle IREFQ mit dem Eingang IREFE sowie den Ausgängen IREFO1, IREFO2, ...IREFOn, IREFOn+1. Die aus m-4 Stromspiegelschaltungen S6, S7, S8,...Sm, Sm+1 sowie einem p-Kanal-Feldeffekttransistor T34 besteht. Ein Eingangssignal am Eingang IREFE wird über den p-Kanal-Feldeffekttransistor T34 in die Stromspiegelschaltung S6 und von dort in die übrigen Stromspiegelschaltung S7, S8, ...Sm, Sm+1 übertragen. Zu diesem Zweck ist der Eingang IREFE mit dem Gateanschluß des Feldeffekttransistors T34, und der Sourceanschluß desselbigen Feldeffektransitors mit der positiven Spannung V_{DD} und sein Drainanschluß mit dem Eingang ES6 der Stromspiegelschaltung S6 verschaltet. Der Ausgang OS6 der Stromspiegelschaltung S6 bildet gleichzeitig auch den Eingang ES der übrigen Stromspiegelschaltung S7, S8, ...Sm, Sm+1. Während die zuletztgenannten Stromspiegelschaltungen noch mit einer positiven Spannung V_{DD} versorgt werden, ist die Stromspiegelschaltung S6 noch zusätzlich mit der Masse GND verbunden.

Alle Stromspiegelschaltungen der Referenzstromquelle IREFQ werden jeweils aus zwei Feldeffekttransistoren gebildet. Die erste Stromspiegelschaltung S6 enthält dabei zwei n-Kanal-Feldeffekttransistoren T35, T36, wobei der Gateanschluß des ersten n-Kanal-Feldeffekttransistors T36 mit dem Gateanschluß und dem Drainanschluß des zweiten n-Kanal-Feldeffekttransistors T35 verbunden ist, diese Anschlüsse bilden auch gleichzeitig den Eingang ES6 der ersten Stromspiegelschaltung S6. Die Sourceanschlüsse dieser beiden Feldeffekttransistoren T35, T36 sind jeweils an Masse GND angeschlossen und der Drainanschluß des ersten Feldeffekttransistors T36 bildet den Ausgang OS6 derselbigen Stromspiegelschaltung. Die übrigen Stromspiegelschaltungen S7, S8,...Sm, Sm+1 weisen einen gemeinsamen ersten p-Kanal-Eingangstransistors T37 und je einen zweiten, dritten ...p-Kanal-Ausgangstransistor T38, T39,...Tk, Tk+1 auf. Der Gateanschluß des ersten p-Kanal-Feldeffekttransistors T37 bildet gemeinsam mit seinem Drainanschluß den Eingang ES und ist zusätzlich mit den Gateanschlüssen der restlichen p-Kanal-Feldeffekttransistoren T38, T39,...Tk, Tkn verbunden. Die Drainanschlüsse der zweiten, dritten, vierten ... p-Kanal-Ausgangstransistoren bilden die Ausgänge IREFO1, IREFO2,... IREFOn, IREFOn+1, während alle Sourceanschlüsse der Feldeffekttransistoren T37, T38, T39, ...Tk, Tk+1 mit einer positiven Spannung V_{DD} verschaltet sind.

## Patentansprüche

1. ECL-kompatible Eingangs-/Ausgangsschaltungen in CMOS-Technik, bei denen die Eingangs-/Ausgangsschaltungen Treiberstufen (TR1, TR2,...TRn), eine Sensorstufe (S), einen Komparator (K), einen Tiefpaß (T) und eine Referenzstromquelle (IREFQ) enthalten, bei denen die Sensorstufe (S), der Komparator (K), der Tiefpaß (T) und die Referenzstromquelle (IREFQ) einen Regelkreis bilden, bei denen der Komparator (K) zwei Eingänge (U_{IST}, U_{REF}) und einen Ausgang (U_{DIFF}) enthalt, bei denen der Ausgang (U_{DIFF}) über den Tiefpaß (T) mit der Referenzstromquelle (IREFQ) verbunden ist, bei denen die Referenzstromquelle (IREFQ) n+1 [n = ganze Zahl] Ausgänge (IREFO1, IREFO2,...IREFOn, IREFOn+1) aufweist und mit je einem musgang an eine Treiberstufe (TR1, TR2,...TRn) und der Sensorstufe (S) verschaltet ist, bei denen ein Ausgang der Sensorstufe (S) mit einem Eingang (U_{IST}) des Komparators (K) verbunden ist, bei denen die Treiberstufen (TR1, TR2,...TRn) und die Sensorstufe (S) je einen externen Anschluß (A1, A2,.. An, SPAD) enthalten, bei denen die Sensorstufe einen Eingang enthält, der mit einer positiven Spannung (V_{DD}) beschaltet ist, bei denen die Treiberstufen (TR1, TR2,...TRn) Eingänge (E1, E2,...En) enthalten, für Eingangssignale der ECL-kompatiblen Eingangs-/Ausgangsschaltungen, bei denen Treiberstufen und die Sensorstufe (S) als Ausgangsstufe aufgebaut sind, die zwei Stromspiegelschaltungen (S1, S2; S4, S5), einen Lastwiderstand (RL, RL'), ein Feldeffektransistorpaar mit einem ersten p-Kanal-Feldeffekttransistor (T1, T19) und einem ersten n-Kanal-Feldeffekttransistor (T2, T20) enthalten, wobei ein Eingang (EA') mit einem Gateanschluß des ersten p-Kanal-Feldeffekttransistors (T1, T19) und einem Gateanschluß des ersten n-Kanal-Feldeffekttransistors (T2, T20) verbunden ist, wobei das Feldeffekttransistorpaar (T1, T2; T19, T20) eine Serienschaltung bildete, wobei ein Sourceanschluß des ersten p-Kanal-Feldeffekttransistors (T1, T19) mit einer positiven Spannung (V_{DD}), ein Sourceanschluß des ersten n-Kanal-Feldeffekttransistors (T2, T20) mit einem Ausgang (OS2, OS5) der ersten Stromspiegelschaltung (S2, S5) verschaltet ist, wobei ein Eingang (ES2, ES5) derselbigen Stromspiegelschaltung mit einem Referenzstromwert (IREF) beschaltet ist, wobei dieselbige Stromspiegelschaltung (S2, S5) mit Masse (GND) verbunden ist, wobei die zweite Stromspiegelschaltung (S1, S4) mit der positiven Spannung (V_{DD}) verbunden ist, ein Eingang (ES1, ES4) derselbigen Stromspiegelschaltung mit einem Drainanschluß des ersten p-Kanal-Feldeffekttransistors (T1, T19) und mit einem Drainanschluß des ersten n-Kanal-Feldeffekttransistors (T2, T20), ein Ausgang (OS1, OS4) derselbigen Stromspiegelschaltung mit einem Lastwiderstand (RL, RL') und mit einem Ausgang (OA, OA') der Ausgangsstufe verschaltet ist und wobei ein weiterer Anschluß des Lastwiderstandes (RL, RL' ) auf eine Spannung (VRD, VRD'') gelegt ist.

2. ECL-kompatible Eingangs-/Ausgangsschaltungen in CMOS-Technik nach Anspruch 1, **dadurch gekennzeichnet,** daß in den Treiberstufen (TR1, TR2,...TRn) vor dem Eingang (EA') des Feldeffekttransistorpaares (T1, T2) mehrere hintereinander geschaltete Inverterstufen (I1, I2) angeordnet sind, daß ein Eingang (EA) der ersten Inverterstufe (I1) mit einem Eingang (E1, E2,.. EN) der Treiberstufen verbunden ist.

3. ECL-kompatible Eingangs-/Ausgangsschaltungen in CMOS-Technik nach Anspruch 1, **dadurch gekennzeichnet,** daß in der Sensorstufe (S) der Eingang (EA') des Feldeffekttransistorpaares (T19, T20) mit einer positiven Spannung (V_{DD}) verschaltet ist.

4. ECL-kompatible Eingangs-/Ausgangsschaltungen in CMOS-Technik nach einem der Ansprüche 1 bis 3, **dadurch gekennzeichnet,** daß die zweite Stromspiegelschaltung (S1, S4) zwei p-Kanal-Feldeffekttransistoren (T3, T4; T21, T22) enthält, daß ein Gateanschluß eines ersten p-Kanal-Feldeffekttransistors (T3, T21) und ein Gateanschluß eines zweiten p-Kanal-Feldeffekttransistors (T4, T22) mit einem Drainanschluß des ersten p-Kanal-Feldeffekttransistors (T3, T21) verbunden ist, der einen Eingang (ES1, ES4) der zweiten, Stromspiegelschaltung (S1, S4) bildet, daß Sourceanschlüsse der zwei p-Kanal-Feldeffekttransistoren (T3, T4; T21, T22) an die positive Spannung (V_{DD}) angeschlossen sind, daß ein Drainanschluß des zweiten p-Kanal-Feldeffekttransistors (T4, T22) einen Ausgang (OS1, OS4) der zweiten Stromspiegelschaltung (S1, S4) bildet, daß die erste stromspiegelschaltung (S2, S4) zwei n-Kanal-Feldeffekttransistoren (T6, T5; T23, T24) enthält, daß ein Gateanschluß eines ersten n-Kanal-Feldeffektransistors (T5, T24) mit einem Gateanschluß und einem Drainanschluß eines zweiten n-Kanal-Feldeffekttransistors (T6, T23) verbunden ist, der den Eingang (ES2, ES5) der ersten Stromspiegelschaltung (S2, S5) bildet, daß Sourceanschlüsse der zwei n-Kanal-Feldeffekttransistoren (T6, T5, T23, T24) an der Masse (GND) angeschlossen sind, daß ein Drainanschluß des ersten n-Kanal-Feldeffekttransistors (T5, T24) einen Ausgang (OS2, OS5) der ersten Stromspiegelschaltung (S2, S5) bildet.

5. ECL-kompatible Eingangs-Ausgangsschaltung in CMOS-Technik nach Anspruch 1, **dadurch gekennzeichnet,** daß der Komparator (K) einen Differenzverstärker mit Stromspiegelschaltung (SDIFF) und zwei Widerstände (W1', W2') enthält, daß der Differenzverstärker aus zwei n-Kanal-Feldeffekttransistoren (T25, T26) mit zwei Eingängen (U_{IST}, U_{REF}) gebildet wird, deren Sourceanschlüsse über einen Drainanschluß eines dritten n-Kanal-Feldeffekttransistors (T29) mit Masse (GND) verbunden ist, daß ein Gateanschluß des dritten n-Kanal-Feldeffekttransistors (T29) mit einem Verbindungspunkt (M) zweier zwischen der positiven Spannung (V_{DD}) und der Masse (GND) geschalteter Widerstände (W1', W2') verbunden ist, daß die Stromspiegelschaltung zwei p-Kanal-Feldeffekttransistoren (T27, T28) enthält, deren Sourceanschlüsse an der positiven Spannung (V_{DD}), ein Drainanschluß eines ersten p-Kanal-Feldeffekttransistors (T28) mit den Gateanschlüssen des ersten und zweiten p-Kanal-Feldeffekttransistors (T28, T27) und mit einem Drainanschluß des ersten n-Kanal-Feldeffekttransistors (T25), ein Drainanschluß des zweiten p-Kanal-Feldeffekttransistors (T27) mit einem Ausgang (U_{DIFF}) und einem Drainanschluß vom zweiten n-Kanal-Feldeffekttransistor (T26) verschaltet ist.

6. ECL-kompatible Eingangs-/Ausgangsschaltung in CMOS-Technik nach Anspruch 5, **dadurch gekennzeichnet,** daß der erste Widerstand (W1') aus zwei in Serie geschalteter p-Kanal-Feldeffekttransistoren (T31, T32) gebildet wird, daß Gate- und Drainanschluß der gleichen p-Kanal-Feldeffekttransistoren gemeinsam verschaltet sind, daß der zweiten Widerstand (W2' ) aus einem n-Kanal-Feldeffekttransistor (T30) gebildet wird, dessen Gate- und Drainanschlüsse zusammengelegt sind.

7. ECL-kompatible Eingangs-/Ausgangsschaltungen in CMOS-Technik nach Anspruch 1, **dadurch gekennzeichnet,** daß der Tiefpaß einen p-Kanal-Feldeffekttransistor (T33) mit Source- und Drainanschluß im Längszweig und Gateanschluß und einen Kondensator (C) im Querzweig enthält.

8. ECL-kompatible Eingangs-/Ausgangsschaltungen in CMOS-Technik nach Anspruch 1, **dadurch gekennzeichnet,** daß die Referenzstromquelle (IREFQ) m-4 [m = ganze Zahl] Stromspiegelschaltungen (S6, S7, S8, ...Sm, Sm+1) und einen p-Kanal-Feldeffekttransistor (T34) enthält, daß ein Eingang (IREFE) der Referenzstromquelle (IREFQ) mit einem Gateanschluß des Feldeffekttransistors (T34), ein Sourceanschluß desselbigen mit der positiven Spannung (V_{DD}) und ein Drainanschluß desselbigen mit einem Eingang (ES6) der ersten Stromspiegelschaltung (S6) verschaltet ist, daß die erste Stromspiegelschaltung (S6) mit Hasse (GND) und ein Ausgang (OS6) derselbigen Schaltung mit dem Eingang (ES) der übrigen Stromspiegelschaltungen (S7, S8,...Sm, Sm+1) verbunden ist, daß diese Stromspiegelschaltungen an die positive Spannung (v_{DD}) angeschlossen sind.

9. ECL-kompatible Eingangs-/Ausgangsschaltungen in CMOS-Technik nach Anspruch 8, **dadurch gekennzeichnet,** daß die erste Stromspiegelschaltung (S6) zwei n-Kanal-Feldeffekttransistoren (T35, T36) enthält, daß ein Gateanschluß des ersten n-Kanal-Feldeffekttransistors (T36) mit einem Gateanschluß und mit einem Drainanschluß des zweiten n-Kanal-Feldeffekttransistors (T35) verbunden ist, die den Eingang (ES6) der ersten Stromspiegelschaltung (S6) bilden, daß Sourceanschlüsse beider Feldeffekttransistoren (T35, T36) an Masse (GND) angeschlossen sind, daß ein Drainanschluß des ersten Feldeffekttransistors (T36) einen Ausgang (OS6) der ersten Stromspiegelschaltung (S6) bildet, daß die übrigen Stromspiegelschaltungen (S7, S8,...Sm, Sm+1) einen gemeinsamen ersten p-Kanal-Eingangstransistor (T37) und je einen zweiten , dritten ... p-Kanal-Ausgangstransistor (T38, T39, ...Tk, Tk+1) enthalten, daß ein Gateanschluß vom p-Kanal-Eingangstransistor (T37) mit einem Drainanschluß desselbigen Transistors, die den Eingang (ES) der ersten Stromspiegelschaltungen bilden, und mit Gateanschlüssen der p-Kanal-Ausgangstransistoren (T38, T39,...Tk, Tk+1) verbunden ist, daß die Drainanschlüsse der zweiten, dritten, ...p-Kanal-Ausgangstransistoren die Ausgänge (IREFO1, IREFO2, ... IREFOn, IREFOn+1) bilden und daß der Sourceanschluß aller Feldeffekttransistoren der übrigen Stromspiegelschaltungen mit einer positiven Spannung (V_{DD}) verschaltet sind.

## Claims

1. ECL-compatible input/output circuits using CMOS technology, in the case of which the input/output circuits contain driver stages (TR1, TR2,...TRn), a sensor stage (S), a comparator (K), a low-pass filter (T) and a reference-current source (IREFQ), in the case of which the sensor stage (S), the comparator (K), the low-pass filter (T) and the reference-current source (IREFQ) form a control loop, in the case of which the comparator (K) contains two inputs (U_{IST}, U_{REF}) and one output (U_{DIFF}), in the case of which the output (U_{DIFF})is connected via the low-pass filter (T) to the reference-current source (ITEFQ), in the case of which the reference-current source (IREFQ) has n+1 [n = integer] outputs (IREF01, IREF02,...IREF0n, IREF0n+1) and in each case one of its outputs is connected to a driver stage (TR1, TR2,...TRn) and to the sensor stage (S), in the case of which one output of the sensor stage (S) is connected to one input (U_{IST}) of the comparator (K), in the case of which the driver stages (TR1, TR2,...TRn) and the sensor stage (S) in each case contain one external connection (A1, A2,...An, SPAD), in the case of which the sensor stage contains an input which is connected to a positive voltage (V_{DD}), in the case of which the driver stages (TR1, TR2,...TRn) contain inputs (E1, E2,...En) for input signals of the ECL-compatible input/output circuits, in the case of which driver stages and the sensor stage (S) are constructed as an output stage and contain two current-mirror circuits (S1, S2; S4, S5), a load resistor (RL, RL'), and a field-effect transistor pair having a first p-channel field-effect transistor (T1, T19) and a first n-channel field-effect transistor (T2, T20), one input (EA') being connected to a gate connection of the first p-channel field-effect transistor (T1, T19) and to a gate connection of the first n-channel field-effect transistor (T2, T20), the field-effect transistor pair (T1, T2; T19, T20) forming a series circuit, a source connection of the first p-channel field-effect transistor (T1, T19) being connected to a positive voltage (V_{DD}), a source connection of the first n-channel field-effect transistor (T2, T20) being connected to one output (OS2, OS5) of the first current-mirror circuit (S2, S5), one input (ES2, ES5) of the same current-mirror circuit being connected to a reference current value (IREF), the same current-mirror circuit (S2, S5) being connected to earth (GND), the second current-mirror circuit (S1, S4) being connected to the positive voltage (V_{DD}), one input (ES1, ES4) of the same current-mirror circuit being connected to a drain connection of the first p-channel field-effect transistor (T1, T19) and to a drain connection of the first n-channel field-effect transistor (T2, T20), one output (OS1, OS4) of the same current-mirror circuit being connected to a load resistor (RL, RL') and to an output (OA, OA') of the output stage, and a further connection of the load resistor (RL, RL') being connected to a voltage (VRD, VRD'').

2. ECL-compatible input/output circuits using CMOS technology according to Claim 1, characterized in that a plurality of series-connected invertor stages (I1, I2) are arranged in the driver stages (TR1, TR2,...TRn) upstream of the input (EA') of the field-effect transistor pair (T1, T2), and in that an input (EA) of the first invertor stage (I1) is connected to an input (E1, E2,...En) of the driver stages.

3. ECL-compatible input/output circuits using CMOS technology according to Claim 1, characterized in that, in the sensor stage (S), the input (EA') of the field-effect transistor pair (T19, T20) is connected to a positive voltage (V_{DD}).

4. ECL-compatible input/output circuits using CMOS technology according to one of Claims 1 to 3, characterized in that the second current-mirror circuit (S1, S4) contains two p-channel field-effect transistors (T3, T4; T21, T22), in that a gate connection of a first p-channel field-effect transistor (T3, T21) and a gate connection of a second p-channel field-effect transistor (T4, T22) are connected to a drain connection of the first p-channel field-effect transistor (T3, T21), which forms an input (ES1, ES4) of the second current-mirror circuit (S1, S4), in that source connections of the two p-channel field-effect transistors (T3, T4; T21, T22) are connected to the positive voltage (V_{DD}), in that a drain connection of the second p-channel field-effect transistor (T4, T22) forms an output (OS1, OS4) of the second current-mirror circuit (S1, S4), in that the first current-mirror circuit (S2, S4) contains two n-channel field-effect transistors (T6, T5; T23, T24), in that a gate connection of a first n-channel field-effect transistor (T5, T24) is connected to a gate connection and to a drain connection of a second n-channel field-effect transistor (T6, T23), which forms the input (ES2, ES5) of the first current-mirror circuit (S2, S5), in that source connections of two n-channel field-effect transistors (T6, T5, T23, T24) are connected to earth (GND), in that a drain connection of the first n-channel field-effect transistor (T5, T24) forms an output (OS2, OS5) of the first current-mirror circuit (S2, S5).

5. ECL-compatible input/output circuit using CMOS technology according to Claim 1, characterized in that the comparator (K) contains a differential amplifier having a current-mirror circuit (SDIFF) and two resistors (W1', W2'), in that the differential amplifier is formed from two n-channel field-effect transistors (T25, T26) having two inputs (U_{IST}, U_{REF}) and whose source connections are connected via a drain connection of a third n-channel field-effect transistor (T29) to earth (GND), in that a gate connection of the third n-channel field-effect transistor (T29) is connected to a connecting point (M) of two resistors (W1', W2') which are connected between the positive voltage (V_{DD}) and earth (GND), in that the current-mirror circuit contains two p-channel field-effect transistors (T27, T28) whose source connections are connected to the positive voltage (V_{DD}), a drain connection of a first p-channel field-effect transistor (T28) is connected to the gate connections of the first and the second p-channel field-effect transistors (T28, T27) and to a drain connection of the first n-channel field-effect transistor (T25), and a drain connection of the second p-channel field-effect transistor (T27) is connected to an output (U_{DIFF}) and to a drain connection of the second n-channel field-effect transistor (T26).

6. ECL-compatible input/output circuit using CMOS technology according to Claim 5, characterized in that the first resistor (W1') is formed from two series-connected p-channel field-effect transistors (T31, T32), in that the gate and the drain connections of the same p-channel field-effect transistors are connected to one another, in that the second resistor (W2') is formed from an n-channel field-effect transistor (T30) whose gate and drain connections are joined together.

7. ECL-compatible input/output circuits using CMOS technology according to Claim 1, characterized in that the low-pass filter contains a p-channel field-effect transistor (T33) having the source and the drain connections in the direct-axis branch and the gate connection and a capacitor (C) in the quadrature-axis branch.

8. ECL-compatible input/output circuits using CMOS technology according to Claim 1, characterized in that the reference-current source (IREFQ) contains m-4 [m = integer] current-mirror circuits (S6, S7, S8, ...Sm, Sm+1) and a p-channel field-effect transistor (T34), in that one input (IREFE) of the reference-current source (IREFQ) is connected to a gate connection of the field-effect transistor (T34), a source connection of the same is connected to the positive voltage (V_{DD}) and a drain connection of the same is connected to an input (ES6) of the first current-mirror circuit (S6), in that the first current-mirror circuit (S6) is connected to earth (GND) and one output (OS6) of the same circuit is connected to the input (ES) of the other current-mirror circuits (S7, S8,...Sm, Sm+1), and in that these current-mirror circuits are connected to the positive voltage (V_{DD}).

9. ECL-compatible input/output circuits using CMOS technology according to Claim 8, characterized in that the first current-mirror circuit (S6) contains two n-channel field-effect transistors (T35, T36), in that a gate connection of the first n-channel field-effect transistor (T36) is connected to a gate connection and to a drain connection of the second n-channel field-effect transistor (T35), which form the input (ES6) of the first current-mirror circuit (S6), in that the source connections of both field-effect transistors (T35, T36) are connected to earth (GND), in that a drain connection of the first field-effect transistor (T36) forms an output (OS6) of the first current-mirror circuit (S6), in that the other current-mirror circuits (S7, S8,...Sm, Sm+1) contain a common first p-channel input transistor (T37) and in each case one second, third ... p-channel output transistor (T38, T39, ...Tk, Tk+1), in that a gate connection of the p-channel input transistor (T37) is connected to a drain connection of the same transistor, which form the input (ES) of the first current-mirror circuits, and to gate connections of the p-channel output transistors (T38, T39, ...Tk, Tk+1), in that the drain connections of the second, third, ... p-channel output transistors form the outputs (IREF01, IREF02, ... IREF0n, IREF0n+1), and in that the source connections of all the field-effect transistors of the other current-mirror circuits are connected to a positive voltage (V_{DD}).

## Revendications

1. Circuits d'entrée/sortie compatibles ECL (logique à émetteurs couplés) en technique CMOS, dans lesquels les circuits d'entrée/sortie comportent des étages d'attaque (TR1, TR2,... TRn), un étage de détection (S), un comparateur (K), un filtre passe-bas (T) et une source de courant de référence (IREFQ), dans lesquels l'étage de détection (S), le comparateur (K), le filtre passe-bas (T) et la source de tension de référence (IREFQ) forment un circuit de régulation, dans lesquels le comparateur (K) comporte deux entrées (U_{IST}, U_{REF}) et une sortie (U_{DIFF}), dans lesquelles la sortie (U_{DIFF}) est reliée, par l'intermédiaire du filtre passe-bas (T), à la source de courant de référence (IREFQ), dans lesquels la source de courant de référence (IREFQ) comporte n+1 [ n = nombre entier] sorties (IREF01, IREF02,...IREF0n, IREF0n+1) et est reliée, respectivement par une sortie, à un étage d'attaque (TR1, TR2,... TRn) et à l'étage de détection (S), dans lesquels une sortie de l'étage de détection (S) est reliée à une entrée (U_{IST}) du comparateur (K), dans lesquels les étages d'attaque (TR1, TR2,... TRn) et l'étage de détection (S) comportent, respectivement, une borne externe (A1, A2,... An, SPAD), dans lesquels l'étage de détection comporte une entrée qui est reliée à une tension positive (V_{DD}), dans lesquels les étages d'attaque (TR1, TR2,... TRn) comportent des entrées (E1, E2, ... En) pour des signaux d'entrée des circuits d'entrée/sortie compatibles ECL, dans lesquels les étages d'attaque et l'étage de détection (S) sont agencés en tant qu'étages de sortie, qui comportent deux circuits de miroir de courant (S1, S2; S4, S5), une résistance de charge (RL, RL'), un couple de transistors à effet de champ comportant un premier transistor à effet de champ à canal p (T1, T19) et un premier transistor à effet de champ à canal n (T2, T20), une entrée (EA') étant reliée à une borne de grille du premier transistor à effet de champ à canal p (T1, T19) et à une borne de grille du premier transistor à effet de champ à canal n (T2, T20), le couple de transistors à effet de champ (T1, T2; T19, T20) formant un circuit série, une borne de source du premier transistor à effet de champ à canal p (T1, T19) étant reliée à une tension positive (V_{DD}), une borne de source du premier transistor à effet de champ à canal n (T2, T20) étant reliée à une sortie (OS2, OS5) du premier circuit de miroir de courant (S2, S5), une entrée (ES2, ES5) dudit premier circuit de miroir de courant étant chargée par une valeur de courant de référence (IREF), ledit premier circuit de mémoire de courant (S2, S5) étant relié à la masse (GND), le deuxième circuit de miroir de courant (S1, S4) étant relié à la tension positive (V_{DD}), une entrée (ES1, ES4) dudit deuxième circuit de miroir de courant étant reliée à une borne de drain du premier transistor à effet de champ à canal p (T1, T19) et à une borne de drain du premier transistor à effet de champ à canal n (T2, T20), une sortie (OS1, OS4) dudit deuxième circuit de miroir de courant étant reliée à une résistance de charge (RL, RL') et à une sortie (OA, OA') de l'étage de sortie, et une autre borne de la résistance de charge (RL, RL') étant appliquée à une tension (VRD, VRD'').

2. Circuits d'entrée/sortie compatibles ECL en technique CMOS suivant la revendication 1, caractérisés en ce que, dans les étages d'attaque (TR1, TR2,... TRn), plusieurs étages inverseurs (I1, I2), reliés en série, sont disposés en amont de l'entrée (EA') du couple de transistors à effet de champ (T1, T2), qu'une entrée (EA) du premier étage inverseur (I1) est reliée à une entrée (E1, E2,...EN) des étages d'attaque.

3. Circuits d'entrée/sortie compatibles ECL en technique CMOS suivant la revendication 1, caractérisés en ce que, dans l'étage de détection (S), l'entrée (EA') du couple de transistors à effet de champ (T19, T20) est reliée à une tension positive (V_{DD}).

4. Circuits d'entrée/sortie compatibles ECL en technique CMOS suivant l'une des revendications 1 à 3, caractérisés en ce que le deuxième circuit de miroir de courant (S1, S4) comporte deux transistors à effet de champ à canal p (T3, T4; T21, T22), qu'une borne de grille d'un premier transistor à effet de champ à canal p (T3, T21) et une borne de grille d'un deuxième transistor à effet de champ à canal p (T4, T22) sont reliées à une borne de drain du premier transistor à effet de champ à canal p (T3, T21), qui forme une entrée (ES1, ES4) du deuxième circuit de miroir de courant (S1, S4), que les bornes de source des deux transistors à effet de champ à canal p (T3, T4, T21, T22) sont reliées à la tension positive (V_{DD}), qu'une borne de drain du deuxième transistor à effet de champ à canal p (T4, T22) forme une sortie (OS1, OS4) du deuxième circuit de miroir de courant (S1, S4), que le premier circuit de miroir de courant (S2, S5) comporte deux transistors à effet de champ à canal n (T6, T5; T23, T24), qu'une borne de grille d'un premier transistor à effet de champ à canal n (T5, T24) est reliée à une borne de grille et à une borne de drain d'un deuxième transistor à effet de champ à canal n (T6, T23), qui forme l'entrée (ES2, ES5) du premier circuit de miroir de courant (S2, S5), que les bornes de source des deux transistors à effet de champ à canal n (T6, T5, T23, T24) sont reliées à la masse (GND), et qu'une borne de drain du premier transistor à effet de champ à canal n (T5, T24) forme une sortie (OS2, OS5) du premier circuit de miroir de courant (S2, S5).

5. Circuit d'entrée/sortie compatible ECL en technique CMOS suivant la revendication 1, caractérisé en ce que le comparateur (K) comporte un amplificateur différentiel ayant un circuit de miroir de courant (SDIFF) et deux résistances (W1', W2'), que l'amplificateur différentiel est formé à partir de deux transistors à effet de champ à canal n (T25, T26) à deux entrées (I_{IST}, U_{REF}), dont les bornes de source sont reliées à la masse, par l'intermédiaire d'une borne de drain d'un troisième transistor à effet de champ à canal n (T29), qu'une borne de grille du troisième transistor à effet de champ à canal n (T29) est reliée à un point de connexion (M) de deux résistances (W1', W2') montées entre la tension positive (V_{DD}) et la masse (GND), que le circuit de miroir de courant comporte deux transistors à effet de champ à canal p (T27, T28), dont les bornes de source sont reliées à la tension positive (V_{DD}), qu'une borne de drain d'un premier transistor à effet de champ à canal p (T28) est reliée aux bornes de grille du premier et du deuxième transistors à effet de champ à canal p (T28, T27) et à une borne de drain du premier transistor à canal n (T25), qu'une borne de drain du deuxième transistor à effet de champ à canal p (T27) est reliée à une sortie (U_{DIFF}) et à une borne de drain du deuxième transistor à effet de champ à canal n (T26).

6. Circuit d'entrée/sortie compatible ECL en technique CMOS suivant la revendication 5, caractérisé en ce que la première résistance (W1') est formée à partir de deux transistors à effet de champ à canal p (T31, T32) montés en série, que les bornes de grille et de drain de ces mêmes transistors à effet de champ à canal p sont reliées entre elles, que la deuxième résistance (W2') est formée à partir d'un transistor à effet de champ à canal n (T30), dont les bornes de grille et de drain sont reliées entre elles.

7. Circuits d'entrée/sortie compatibles ECL en technique CMOS suivant la revendication 1, caractérisés en ce que le filtre passe-bas comporte un transistor à effet de champ à canal p (T33) ayant, dans la branche longitudinale, une borne de source et une borne de drain et, dans la branche transversale, une borne de grille et un condensateur (C).

8. Circuits entrée/sortie compatibles ECL en technique CMOS suivant la revendication 1, caractérisés en ce que la source de courant de référence (IREFQ) comporte m-4 [m = nombre entier] circuits de miroir de courant (S6, S7, S8, ...Sm, Sm+1) et un transistor à effet de champ à canal p (T34), qu'une entrée (IREFE) de la source de courant de référence (IREFQ) est reliée à une borne de grille du transistor à effet de champ (T34), qu'une borne de source dudit transistor est reliée à la tension positive (V_{DD}) et qu'une borne de drain dudit transistor est reliée à une entrée (ES6) du premier circuit de miroir de courant (S6), que le premier circuit de miroir de courant (S6) est relié à la masse (GND) et qu'une sortie (OS6) dudit circuit est reliée à l'entrée (ES) des autres circuits de miroir de courant (S7, S8,...Sm, Sm+1), et que ces circuits de miroir de courant sont reliés à la tension positive (V_{DD}).

9. Circuits d'entrée/sortie compatibles ECL en technique CMOS suivant la revendication 8, caractérisés en ce que le premier circuit de miroir de courant (S6) comporte deux transistors à effet de champ à canal n (T35, T36), qu'une borne de grille du premier transistor à effet de champ à canal n (T36) est reliée à une borne de grille et à une borne de drain du deuxième transistor à effet de champ à canal n (T35), qui forment l'entrée (ES6) du premier circuit de miroir de courant (S6), que les bornes de source des deux transistors à effet de champ (T35, T36) sont reliées à la masse (GND), qu'une borne de drain du premier transistor à effet de champ (T36) forme une sortie (OS6) du premier circuit de miroir de courant (S6), que les autres circuits de miroir de courant (S7, S8,...Sm, Sm+1) comportent un premier transistor d'entrée à canal p commun (T37) et, respectivement, un deuxième, un troisième, ... transistors de sortie à canal p (T38, T39, ... Tk, Tk+1), qu'une borne de grille du transistor d'entrée à canal p (T37) est reliée à une borne de drain de ce même transistor, qui forme l'entrée (ES) du premier circuit de miroirs de courant, et qui est reliée aux bornes de grille des transistors de sortie à canal p (T38, T39,...Tk, Tk+1), que les bornes de drain des deuxième, troisième, ... transistors de sortie à canal p forment les sorties (IREF01, IREF02, ... IREF0n, IREF0n+1), et que la borne de source de tous les transistors à effet de champ des autres circuits de miroirs de courant sont reliés à une tension positive (V_{DD}).
